# EUROPEAN PATENT SPECIFICATION

(11) **EP 2 039 811 B1**
(45) Date of publication and mention of the grant of the patent: **19.09.2012**
(21) Application number: 07744206.9
(22) Date of filing: 28.05.2007
(51) Int. Cl.: C30B 29/06, C30B 15/22

(54) **System for manufacturing silicon single crystal and method for manufacturing silicon single crystal using this system**
System zur Herstellung von Siliciumeinkristallen und Verfahren zur Herstellung von Siliciumeinkristallen unter Verwendung des Systems
Système de fabrication d'un cristal de silicium unique et procédé de fabrication d'un cristal de silicium unique au moyen dudit système

(30) Priority: 26.06.2006 JP 2006175435
(43) Date of publication of application: 25.03.2009
(73) Proprietor: Shin-Etsu Handotai Co., Ltd., Tokyo (JP)
(72) Inventor: IIDA, Makoto, Nishishirakawa-gun, Fukushima 961-8061 (JP); MITAMURA, Nobuaki, Nishishirakawa-gun, Fukushima 961-8061 (JP); YANAGIMACHI, Takahiro, Nishishirakawa-gun, Fukushima 961-8061 (JP)
(74) Representative: Wibbelmann, Jobst
(86) International application number: PCT/JP2007/060772
(87) International publication number: WO 2008/001569

(56) References cited:
- EP-A1- 1 640 484
- WO-A1-2005/054549
- WO-A1-2006/064610
- JP-A- 2005 015 312
- JP-A- 2005 162 558

## Description

### TECHNICAL FIELD

The present invention relates to a manufacturing system that designs optimum manufacturing conditions for efficiently producing a silicon single crystal with a desired crystal quality and less crystal defects in particular at a high yield, and to a method for manufacturing a silicon single crystal using this system.

### BACKGROUND ART

In recent years, a quality demand for a silicon single crystal manufactured based on the Czochralski method (which will be abbreviated to the CZ method hereinafter) that serves as a substrate material has been increased, as a device is finer, which is involved by realization of high integration of a semiconductor circuit. In particular, defects called Grown-in defects originated in single-crystal growth that degrade oxide dielectric breakdown voltage characteristics or device characteristics, e.g., an FPD (Flow Pattern Defect), an LSTD (Laser Scattering Tomography Defect), or a COP (Crystal Originated Particle) are present in a single crystal, and a reduction in density and in size of such a defect gains recognition.

Prior to an explanation of these defects, a description will be first given as to general knowledge about a factor that determines an injected concentration of each of a vacancy type point defect called vacancy (which may be abbreviated to V hereinafter) and an interstitial silicon type point defect called interstitial-Si (which may be abbreviated to I hereinafter) which are taken into a silicon single crystal during crystal growth.

In a silicon single crystal, a V region means a region having many voids generated from insufficiency of silicon atoms, an I region means a region having many agglomerates of silicon atoms or many dislocation loop clusters that is produced due to presence of excessive silicon atoms, and a Neutral (which may be abbreviated to N hereinafter) region with less excess and deficiency of atoms is present between the V region and the I region. Further, it has been revealed that the Grown-in defect (e.g., the FPD, the LSTD, or the COP) is produced when V or I is supersaturated and the Grown-in defect is not present if its concentration is equal to or lower than a saturation concentration even though there is a minor deviation in atoms.

It was confirmed that a concentration of each of both the point defects is determined based on a relationship between a pulling rate (a growth rate) F of a crystal in the CZ method and a temperature gradient G of a solid-liquid interface along an axis direction in a crystal, and that defects called OSF (Oxidation Induced Stacking Fault) are distributed in a ring-like shape (which may be referred to as an OSF ring hereinafter) around the V region as seen from a cross section in a vertical direction (a crystal radial direction) with respect to a crystal growth axis.

Classifying these grown-in defects, when a growth rate is a relatively high rate, e.g., approximately 0.6 mm/min or more, grown-in defects such as the FPDs, the LSTDs, or the COPs due to voids generated from agglomeration of the vacancy type point defects are present in an entire region in the crystal radial direction with a high density, and form the V region. Furthermore, when the growth rate is 0.6 mm/min or below, the OSF ring is generated from a periphery of the crystal as the growth rate is reduced, defects such as L/D (Large Dislocation: an abbreviation of an interstitial dislocation loop), LSEPDs (Large Secco Etch Pit Defects), or LFPDs (Large Flow Pattern Defects) that are considered as a factor of dislocation loops based on an agglomeration of interstitial silicon are present outside this ring and form the I region. Moreover, when the growth rate is reduced to approximately 0.4 mm/min or below, the OSF ring is contracted and annihilated at the center of a wafer, and the whole area in the radial direction becomes the I region.

Moreover, as explained above, an N region in which any of, FPDs, LSTDs and COPs due to vacancies, LSEPDs and LFPDs due to dislocation loops based on interstitial silicon, and further OSFs is not present is provided between the V region and the I region outside the OSF ring.
This N region is usually obliquely present with respect to a growth axis direction within a plane including the growth axis when the growth rate is reduced, and hence this region is only partially present within a plane obtained by cutting a single crystal in a direction vertical to the growth axis direction. As to this N region, Voronkov's theory (see, e.g., V. V. Voronkov, Journal of Crystal Growth, vol. 59 (1982), pp. 625-643) claims that a parameter F/G as a ratio between the pulling rate F and a temperature gradient G of the crystal solid-liquid interface along the axis direction determines a total concentration of point defects. Although the pulling rate is fixed in the radial direction, since G has a distribution in the radial direction, there can be obtained a crystal alone that the V region is formed at the center and the I region is provided at the periphery with the N region sandwiched at a given pulling rate, for example.

Thus, manufacture of a crystal having the N region formed in the whole area in the radial direction, N region of which is only partially present in the radial direction at a given pulling rate in a conventional example but is expanded to the entire area in the crystal radial direction, has been recently enabled by improving a radial distribution of G, e.g., pulling the crystal while gradually reducing the pulling rate F. Additionally, expansion in a lengthwise direction of the crystal having the N region formed in the whole area in the radial direction can be achieved to some extent by pulling while maintaining the pulling rate at the moment that this N region is expanded to the entire area in the crystal radial direction. Further, adjusting the pulling rate so that F/G can be fixed while considering and correcting a change in G with growth of the crystal enables expanding the crystal having the N region formed in the whole area in the radial direction to some extent in a growth direction (see, e.g., Japanese Patent No. 3460551).

However, a margin (a control range) of the pulling rate enabling acquisition of the N region in the whole area in the radial direction is extremely narrow, and it is impossible to continuously manufacture the crystal having the N region conforming to a target quality standard over the entire length of a straight body by using the same manufacturing conditions that have been once set even if manufacture of the crystal having the N region over the entire length of a straight body of a single crystal is once realized. Thus, in design of manufacturing conditions that realize the N region over the entire length of the straight body, an operation, i.e., constantly organizing achievement data actually obtained from manufacture, e.g., operation achievement data (e.g., a pulling rate, a number of revolutions of a crucible, or a temperature pattern) of manufacturing conditions and crystal quality achievement data, performing data processing, e.g., analysis of such data, and reviewing the manufacturing conditions based on a result of this data processing is repeatedly carried out. Japanese Patent Application Laid-open No. 2005-162558 discloses a system for manufacturing a silicon single crystal that automatically calculates manufacturing conditions based on achievement data in design of the manufacturing conditions.

However, even if the manufacturing conditions based on the achievement data is reviewed in order to enable manufacture of the crystal having the N region over the entire length of the straight body of the single crystal as above, the N region cannot be abruptly obtained and the single crystal deviates greately from the target quality standard in some cases. There is infrequently a case where a quality deviates from the standard over the entire region of the straight body.

### DISCLOSURE OF INVENTION

In view of the above-explained problems, it is an object of the present invention to provide a system for manufacturing a silicon single crystal that can more assuredly obtain a silicon single crystal having a desired crystal quality and realize an improvement in productivity or yield, and a method for manufacturing a silicon single crystal using this system.

To achieve this object, the present invention provides a system for manufacturing a silicon single crystal which designs manufacturing conditions under which a value of a ratio F/G between a pulling rate F and a temperature gradient G of a crystal solid-liquid interface along an axis direction is controlled to fall within a predetermined range in order that a crystal quality of a silicon single crystal manufactured by a pulling apparatus using the Czochralski method falls within a target standard, comprising, based on automation, at least:
means 1 for tentatively designing manufacturing conditions of a silicon single crystal that is manufactured in a subsequent batch from a crystal quality result of a silicon single crystal manufactured in a previous batch;
means 2 for predicting an amount of change in F and/or G in the subsequent batch caused due to constituent members of the pulling apparatus used in the subsequent batch and calculating a correction amount so that a value of F/G is controlled to fall within the predetermined range;
means 3 for predicting an amount of change in F and/or G in the subsequent batch caused due to a manufacturing process in the subsequent batch and calculating a correction amount so that a value of F/G is controlled to fall within the predetermined range; and
means 4 for adding the correction amount for F and/or G calculated by the means 2 and/or the means 3 to the manufacturing conditions tentatively designed by the means 1 to calculate manufacturing conditions of the silicon single crystal that is manufactured in the subsequent batch.

If such a system for manufacturing a silicon single crystal according to the present invention is provided, since not only manufacturing conditions for a silicon single crystal that is manufactured in the subsequent batch are designed from a crystal quality result of a silicon single crystal manufactured in the previous batch like a conventional manufacturing system but also this design is determined as a tentative design and a correction for a change in F and/or G caused due to constituent members of the pulling apparatus used in the subsequent batch or a manufacturing process in the subsequent batch can be added, the manufacturing conditions enabling highly accurately controlling a value of F/G to fall within a predetermined range can be designed, thereby manufacturing the silicon single crystal having a crystal quality further assuredly controlled to fall within a target standard. Therefore, the silicon single crystal having a desired crystal quality can be manufactured with high productivity and a high yield.
Further, since the manufacturing conditions are automatically designed, an operation burden on design can be reduced, an operation time can be decreased, and the manufacturing conditions can be accurately calculated and designed, thereby improving the efficiency.
Furthermore, the predetermined range of the value of F/G is not restricted in particular, and it can be appropriately set in accordance with the desired crystal quality (a standard or a specification).

At this time, it is preferable that the means 2 performs the calculation from at least replacement and/or a change with time of the constituent members of the pulling apparatus used in the subsequent batch.
As explained above, the means 2 predicts an amount of change in F and/or G in the subsequent batch and calculates the correction amount from at least replacement and/or a change with time of the constituent members of the pulling apparatus used in the subsequent batch, thereby designing the manufacturing conditions enabling further assuredly controlling the value of F/G to fall within the predetermined range.

Moreover, it is preferable that the constituent members as factors of the change in F and/or G are at least one of a wire to pull the silicon single crystal to be manufactured, a quartz crucible that accommodates a raw material of the silicon single crystal, a graphite crucible that supports the quartz crucible, and a heater that melts the raw material of the silicon single crystal.
In the constituent members of the pulling apparatus for the silicon single crystal, the quartz crucible, the graphite crucible, and the heater greatly affect a temperature gradient G of the crystal solid-liquid interface along the axis direction, and the wire greatly affects the pulling rate F. Therefore, at least one of these members is determined as a target constituent member that can be a factor of a change in F and/or G, thereby further accurately predicting an amount of change in F and/or G in the subsequent batch.

Additionally, it is preferable that the means 3 performs the calculation from at least one of a time from end of melting the raw material to start of pulling the silicon single crystal and a difference between a cumulative length of silicon single crystals pulled before and a cumulative length as an initial setting in the same batch in multi-pulling.

As explained above, the means 3 performs the calculation from at least one of the time from end of melting the raw material to start of pulling the silicon single crystal and a difference between the cumulative length of the silicon single crystals pulled before and the cumulative length as the initial setting in the same batch in multi-pulling, thereby designing the manufacturing conditions enabling further assuredly controlling a value of F/G to fall within the predetermined range.

Furthermore, the present invention provides a method for manufacturing a silicon single crystal that uses the system for manufacturing a silicon single crystal to manufacture a silicon single crystal.
As explained above, when the method for manufacturing a silicon single crystal that manufactures a silicon single crystal by using the system for manufacturing a silicon single crystal is provided, manufacturing conditions of a silicon single crystal that is manufactured in the subsequent batch can be tentatively designed from a crystal quality result of a silicon single crystal manufactured in the previous bath, correction with respect to a change in F and/or G caused due to the constituent members of the pulling apparatus used in the subsequent batch or a manufacturing process in the subsequent batch can be added, and hence manufacturing conditions that enables further accurately controlling a value of F/G to fall within the predetermined range can be designed, thereby efficiently manufacturing the silicon single crystal having a crystal quality further assuredly controlled to fall within a target standard. Therefore, the silicon single crystal having a desired crystal quality can be obtained with high productivity and a high yield.

At this time, an N-region single crystal can be manufactured.
In this manner, the N-region single crystal having a narrow margin in particular can be manufactured based on the method for manufacturing a silicon single crystal according to the present invention, thus efficiently obtaining the single crystal with less crystal defects.

Additionally, it is preferable that a correction amount calculated by the means 2 and/or the means 3 is periodically reviewed.
When the correction amount calculated by the means 2 and/or the means 3 is periodically reviewed in this manner, design of the conditions for maintaining F/G in the predetermined range can be further optimized.

As explained above, according to the system for manufacturing a silicon single crystal and the method for manufacturing a silicon single crystal using this system of the present invention, even if, e.g., the constituent members of the pulling apparatus are replaced, the manufacturing conditions considering an influence on F or G can be designed, and the silicon single crystal having a desired crystal quality can be manufactured, thus realizing an improvement in productivity and a yield. Further, this design of the optimum manufacturing conditions can be automatically carried out, and hence the efficiency is excellent.

### BRIEF DESCRIPTION OF DRAWINGS

FIG. 1 is a schematic block diagram showing an example of a system for a manufacturing a silicon single crystal according to the present invention;
FIG. 2 is a flowchart showing an example of a procedure of a method for manufacturing a silicon single crystal according to the present invention;
FIG. 3 is a block schematic view showing an example of a pulling apparatus that can configure the system for manufacturing a silicon single crystal according to the present invention;
FIG. 4 is a graph showing an example of a correction amount calculated by means 2; and
FIG. 5 is a graph showing an example of a correction amount calculated by means 3.

### BEST MODES FOR CARRYING OUT THE INVENTION

Embodiments according to the present invention will now be explained hereinafter, but the present invention is not restricted thereto.
In a conventional example is disclosed a system for manufacturing a silicon single crystal using the CZ method that designs manufacturing conditions for a silicon single crystal that is manufactured in a subsequent batch by reviewing the manufacturing conditions from a result of a crystal quality of a silicon single crystal pulled in a previous batch, for example.
However, even if the conventional system is used to newly design the manufacturing conditions again, a silicon single crystal greatly deviating from a target quality standard may be pulled in some cases. A case where a quality does not meet the standard over the entire region of a straight body is occasionally observed.

Thus, the present inventors keenly examined factors of such great deviation from a desired crystal quality (especially, an N region) and discovered that the problem occurs due to constituent members of the pulling apparatus or a manufacturing process of a single crystal.

That is, as factors concerning the constituent members of the pulling apparatus, there is, for example, replacement of the constituent members and, it was found that, even if a crystal having, e.g., the N region is pulled in a previous batch and a silicon single crystal is manufactured under manufacturing conditions designed based on a result of a crystal quality of this pulled crystal in a batch after replacing a wire to pull the crystal, a quartz crucible accommodating a raw material of the crystal, a graphite crucible that supports the quartz crucible, or a heater that melts the raw material in particular, the N region cannot be formed like the previous batch and a frequency that a quality deviates from the standard is high.

As a result of advancing the examination, it was confirmed that, when the wire is replaced as a specific example, setting the pulling rate to a slightly high rate enables realizing compensation based on stretch of the wire, thereby achieving a target pulling rate. Further, it was revealed that correcting the pulling rate to be slightly reduced enables providing the appropriate pulling rate when the graphite crucible is replaced and that correcting the pulling rate to be slightly increased enables providing the appropriate pulling rate when the heater is replaced.

Further, these constituent members of the pulling apparatus vary in batches due to, e.g., degradation with elapse of an operating time. Furthermore, for example, a weight of the quartz crucible that is replaced in accordance with each batch fluctuates in a given range, and a movement amount of a position (a different from a standard position) of the quartz crucible that has been moved in such a manner that a melt level position of the raw material remains the same predetermined position at start of pulling is also changed due to a life of the graphite crucible, a degradation state and any other factors. It was found that optimum manufacturing conditions for achieving the N-region crystal in accordance with these changes also gradually vary.

Moreover, as factors concerning a manufacturing process of the single crystal, there are, e.g., a time that is required before start of pulling a silicon single crystal and includes a time that the single crystal is disordered to be again melted, a difference between a cumulative length of silicon single crystals pulled before and a cumulative length as an initial setting in the same batch in case of multi-pulling for growing a plurality of silicon single crystals in one quartz crucible, and others, and it was revealed that these factors affect, e.g., a pulling rate that can achieve a desired crystal quality of the N region and others.

The present inventors examined an amount of influence (an amount of change) on the pulling rate F or a temperature gradient G of the crystal solid-liquid interface along the axis direction due to replacement or a change with time of the above-explained constituent members of the pulling apparatus that greatly affect a crystal quality, or an amount of influence due to a manufacturing process in a subsequent batch that greatly affects a crystal quality, respectively, and discovered that pulling the silicon single crystal under manufacturing conditions obtained by previously correcting conditions designed by the conventional system for the amount of influence in accordance with the examinations enables further assuredly obtaining the silicon single crystal having a desired crystal quality, thus bringing the present invention to completion.

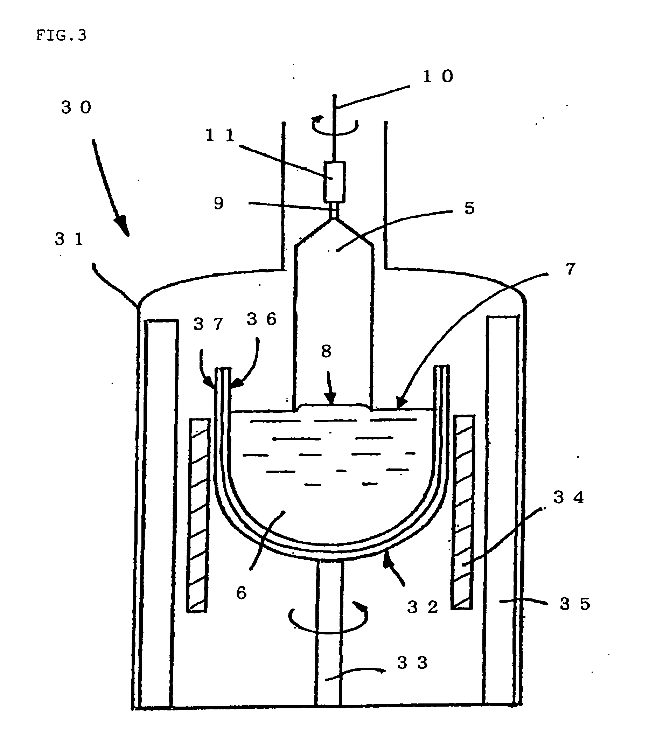

An embodiment according to the present invention will now be specifically explained hereinafter with reference to the drawings.
Prior to an explanation of a system for manufacturing a silicon single crystal according to the present invention, a structure of a single-crystal pulling apparatus adopting the CZ method will be first described. FIG. 3 shows an example of the structure.
As shown in FIG. 3, constituents of this single-crystal pulling apparatus 30 include a pulling chamber 31, a crucible 32 provided in the pulling chamber 31, a heater 34 arranged around the crucible 32, a crucible holding shaft 33 that rotates the crucible 32 and its rotation mechanism (not shown), a seed chuck 11 that holds a seed crystal 9 of silicon, a wire 10 that pulls up the seed chuck 11, and a take-up mechanism (not shown) that rotates or takes up the wire 10. A quartz crucible 36 is provided on the inner side of the crucible 32 on a side where a silicon melt 6 is accommodated, and a graphite crucible 37 is provided on the outer side of the same. Moreover, a heat insulating material 35 is arranged around the outer side of heater 34.
A silicon single crystal 5 is pulled from the silicon melt 6 (a melt level 7) as a raw material by the wire 10 to form a crystal solid-liquid interface 8.

As this single-crystal pulling apparatus 30, a apparatus that can pull a single crystal in accordance with manufacturing conditions obtained by the single-crystal manufacturing system of the present invention can suffice, this apparatus is not restricted in particular, and a conventionally utilized apparatus can be adopted, for example. Additionally, a pulling apparatus adopting an MCZ method that applies a magnetic field can be used.

Further, the following system for manufacturing a silicon single crystal according to the present invention is configured with respect to such a single-crystal pulling apparatus 30, and a silicon single crystal having a desired crystal quality can be pulled and manufactured based on manufacturing conditions for the silicon single crystal automatically calculated by this manufacturing system.

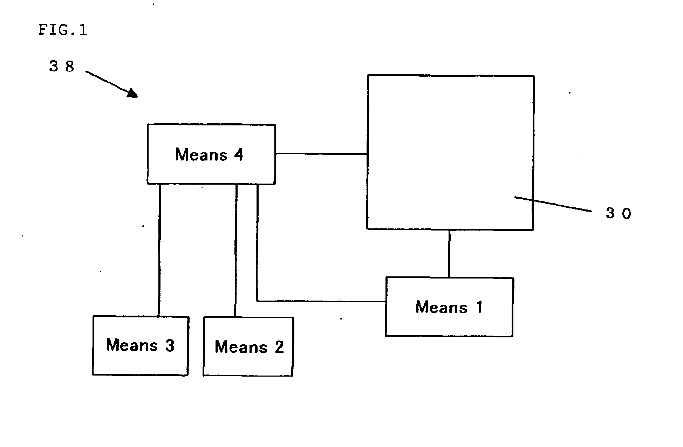

FIG. 1 is a schematic view showing an example of the system for manufacturing a silicon single crystal according to the present invention.
The manufacturing system 38 according to the present invention has means 1 that is connected with, e.g., the pulling apparatus 30 and tentatively designs manufacturing conditions for a silicon single crystal that is manufactured in a subsequent batch from a crystal quality result of a silicon single crystal manufactured in a previous batch. Furthermore, means 2 that predicts an amount of change in F and/or G of the subsequent batch caused due to each constituent member in the pulling apparatus 30 and calculates a correction amount for this change and means 3 that predicts an amount of change in F and/or G of the subsequent batch caused due to a manufacturing process and calculates a correction amount for this change are arranged in such a manner that a value of F/G in the subsequent batch can be controlled to fall within the predetermined range.

Furthermore, there is also arranged means 4 that is connected with the means 1, the means 2, and the means 3 and adds the correction amount of F and/or G calculated by the means 2 and/or the means 3 to the manufacturing conditions tentatively designed by the means 1 to calculate manufacturing conditions for the silicon single crystal that is manufactured in the subsequent batch. This means 4 is further connected with the pulling apparatus 30, the silicon single crystal can be pulled based on the manufacturing conditions obtained by the means 4.

It is to be noted that above-explained each means is configured with a computer and can automatically execute data processing based on, e.g., a preset program. Therefore, occurrence of, e.g., a miscalculation due to a manual procedure can be effectively avoided to accurately execute processing, data can be rapidly processed to derive manufacturing conditions, and hence an operating time involved by design can be greatly reduced, thereby improving a work efficiency.

Each means will now be explained. As the means 1, one equal to the invention that is disclosed in, e.g., Japanese Patent Application Laid-open No. 2005-162558 and obtained by the present inventors can be utilized. As explained above, this means reviews manufacturing conditions, e.g., a pulling rate or a number of revolutions of the crucible based on a crystal quality result (including manufacturing conditions and achievement data of the previous batch, target and achievement data of a crystal quality, and others) of the silicon single crystal in the previous batch, and automatically calculates manufacturing conditions in the subsequent batch. This means 1 can first design fundamental conditions as the manufacturing conditions in the subsequent batch. It is to be noted that this means is not restricted to one disclosed in Japanese Patent Application Laid-open No. 2005-162558.

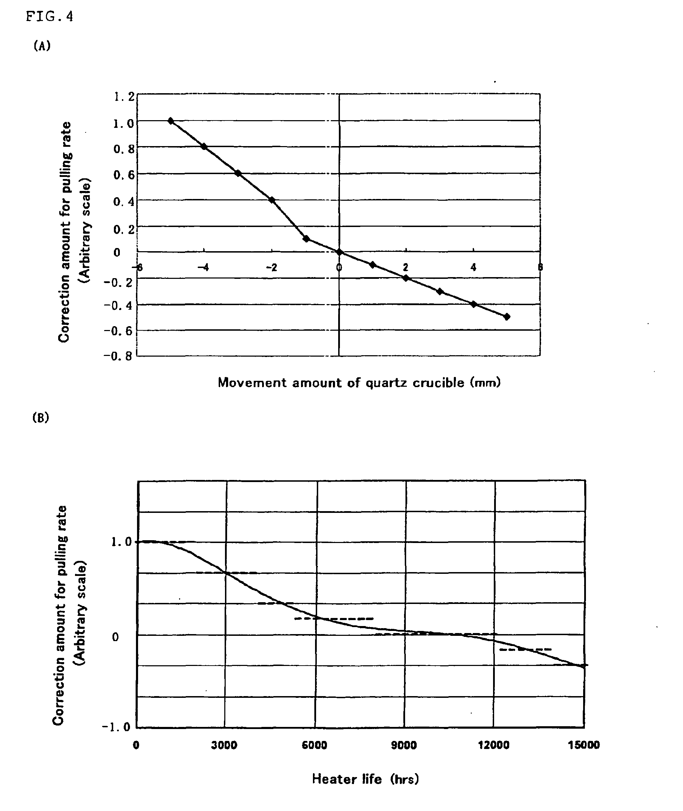

The means 2 obtains a correction amount for a change caused due to each constituent member of the pulling apparatus 30 such as replacement or a change with time of, e.g., the wire 10, the quartz crucible 36, the graphite crucible 37, or the heater 34 in factors that affect/change F or G. Furthermore, it also obtains a correction amount for a change in weight of the quartz crucible 36 or a movement amount, i.e., a positional difference between a standard position and a position after movement of the quartz crucible 36 when the quartz crucible 36 is moved in such a manner that a position of the melt level 7 of the silicon melt 6 accommodated in the quartz crucible 36 is set the predetermined same position at start of pulling the single crystal. At this time, a value of F/G is taken into consideration and the optimum correction amount is calculated so as to obtain a desired crystal quality. This can be also applied to the later-explained means 3.
Graphs in FIG. 4 show examples of (A) a correction amount for an amount of change caused due to the crucible 32 and (B) a correction amount for an amount of change caused due to the heater 34 for acquisition of an N-region single crystal, respectively. In more detail, (A) shows a correction amount for a movement amount of the quartz crucible 36 that is moved in such a manner that a position of the melt level 7 takes a predetermined position from a standard position at start of pulling the single crystal, and (B) shows a correction amount for a heater life. Additionally, when the wire is replaced, for example, F can be corrected and adjusted to a higher rate as explained above. These correction amounts can be changed in many ways by, e.g., manufacturers of the constituent members.

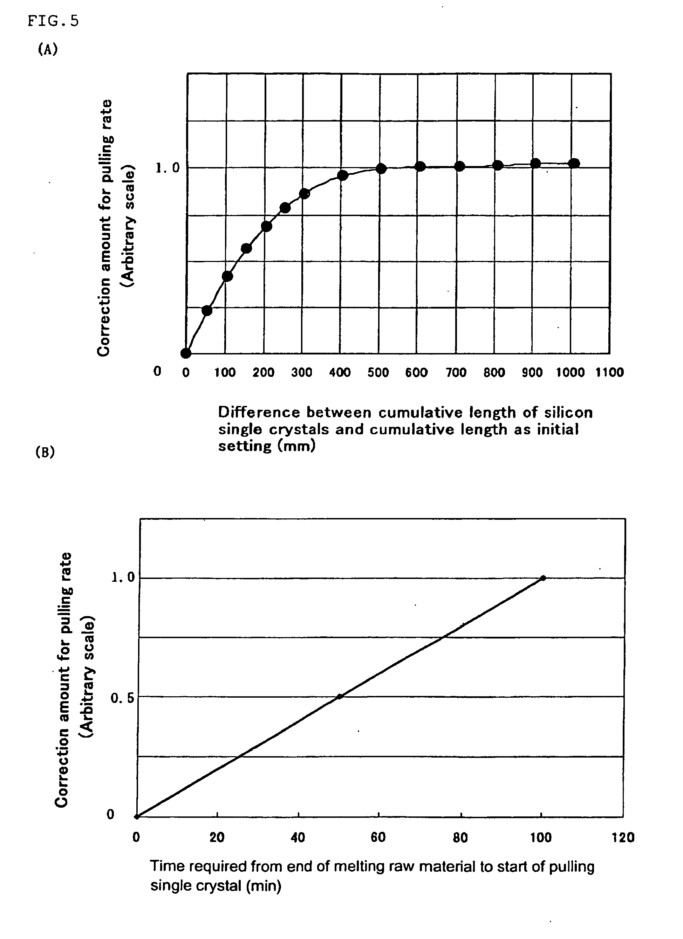

The means 3 checks and predicts an amount of change in F or G caused due to a manufacturing process in the subsequent batch, thereby obtaining a correction amount. As the manufacturing process that is a factor of a change in F or G, there is, e.g., a time required from end of melting the raw material to start of pulling the silicon single crystal. Further, in case of, e.g., multi-pulling where a plurality of single crystals are pulled in the same batch, there is a difference between a cumulative length of previously pulled silicon single crystals and a cumulative length as an initial setting in the same batch. That is, in multi-pulling, a single crystal is pulled by a predetermined length based on an initial setting, then a raw material is added, and the single crystal is further pulled, but completely matching a length of this pulled single crystal with an initial set value is difficult, and occurrence of such a deviation results in the factor of change.
The means 3 can obtain a correction amount for these factors.
Graphs in FIG. 5 show (A) a difference between a cumulative length of silicon single crystals pulled before and a cumulative length as an initial setting in the same batch in multi-pulling and (B) an example of a correction amount for a time required from end of melting a raw material to start of pulling the single crystal to obtain an N-region single crystal, respectively.

It is to be noted that the factors considered in the means 2 or the means 3 are not restricted to those explained above, and the factors each having a particularly high degree of influence have been exemplified above, and elements that affect F and/or G can be appropriately added. For example, when the heater is replaced, a correction amount considering an amount of influence on F or G can be added by considering a manufacturer or the like of the heater and changing an arrangement position in the apparatus.
Introducing the above-explained correction by the means 2 or the means 3 enables approximating a crystal quality of the silicon single crystal to be pulled to a target crystal quality.

Further, the means 4 adds the correction amount obtained by the means 2 and/or the means 3 to the manufacturing conditions tentatively designed by the means 1 to calculate manufacturing conditions that are applied to the subsequent batch or to pulling of the next crystal. Pulling the next crystal by the pulling apparatus 30 based on the manufacturing conditions calculated in such a manner that a desired crystal quality can be obtained, i.e., a value of F/G can be controlled to fall within a predetermined range associated with the crystal quality enables pulling the silicon single crystal 5 having the desired crystal quality.

According to the above-explained system 38 for manufacturing a silicon single crystal of the present invention, manufacturing conditions for the subsequent batch are not just designed by considering achievement data in the previous batch like the conventional system but the manufacturing conditions are obtained by considering factors that change F and/or G in the subsequent batch which are not taken into consideration in the convention and performing correction with respect to such factors, and hence the silicon single crystal having a desired crystal quality, especially the N region can be further assuredly manufactured as compared with the conventional manufacturing system.

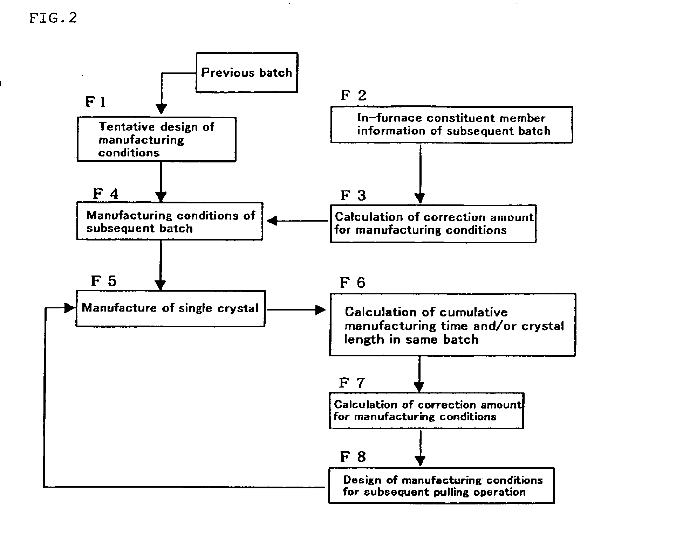

An example of a method for manufacturing a silicon single crystal using the manufacturing system 38 according to the present invention will now be explained with reference to a flowchart of FIG. 2.
First, for example, based on a method disclosed in Japanese Patent Application Laid-open No. 2005-162558, the means 1 tentatively designs manufacturing conditions required to provide a target crystal quality to a silicon single crystal that is pulled in the subsequent batch from manufacturing conditions and achievement data of the previous batch and a target and achievement data of the crystal quality (F1).

Further, in the pulling apparatus 30 that is used in the subsequent batch, information of constituent members that affect a temperature gradient G of the crystal solid-liquid interface along the axis direction or the pulling rate F is confirmed (F2). As explained above, information of, e.g., a manufacturer, an operating time, a state obtained due to a change with time, execution/inexecution of replacement, and others of each of the quartz crucible 36, the graphite crucible 37, the heater 34, the wire 10, and others is confirmed.

Based on such information, the means 2 predicts an amount of change in F and/or G by, e.g., an examination, and calculates a correction amount in such a manner the single crystal that is pulled in the subsequent batch has a desired crystal quality (F3).
Specifically, in regard to a parameter that directly affects the pulling rate F like replacement of the wire as well as a parameter that affects G like replacement of the heater or the graphite crucible or a weight of the quartz crucible, a correction amount is obtained in accordance with each amount of change. At this time, an optimum correction amount can be obtained from an examination result of a crystal quality when each condition is changed.

Further, the means 4 designs manufacturing conditions of the single crystal that is pulled in the subsequent batch by adding the correction amount obtained by the means 2 to the manufacturing conditions tentatively designed by the means 1 (F4).
A first silicon single crystal in multi-pulling is manufactured under the manufacturing conditions (F5).

Subsequently, in multi-pulling where, e.g., a plurality of single crystals are pulled in the same batch, the means 3 calculates a time from end of melting to start of pulling a silicon single crystal and/or a difference between a cumulative length of silicon single crystals pulled before and a cumulative length as an initial setting in the same batch (F6), and calculates a correction amount of manufacturing conditions of a silicon single crystal that is to be pulled next (F7). That is, the correction amount obtained at F7 is added to the manufacturing conditions acquired at F4 (the manufacturing conditions obtained by performing correction by the means 2 with respect to the manufacturing conditions acquired by the means 1) to design manufacturing conditions of the single crystal that is to be pulled next (F8), thereby manufacturing the second and subsequent silicon single crystals under the manufacturing conditions (F5).

It is to be noted that the present invention is not restricted to the foregoing example, and correction calculated from, e.g., a movement amount of a position of the quartz crucible 36 required to set, e.g., the melt level 7 to a predetermined position can be appropriately added to the manufacturing conditions derived by the means 1 as explained above.
Necessary correction contents can be determined each time based on a cost, a target quality level, and others.

Furthermore, it is good to periodically review the correction amounts calculated by the means 2 and the means 3. That is, when calculating these correction amounts, although a formula that seems appropriate from, e.g., past experiences or data can be applied to calculate these amounts, more appropriate correction amounts can be derived by periodically verifying whether this correction formula is correct and appropriately changing the correction formula. When such review is carried out, reproducibility of a desired crystal quality can be further improved.

As explained above, in the method for manufacturing a silicon single crystal according to the present invention, correction is carried out further in accordance with a change in F and/or G caused due to each constituent member of the pulling apparatus 30 used in a subsequent batch or a manufacturing process in the subsequent batch in such a manner that F/G falls within a desired range as against the conventional manufacturing method for manufacturing a single crystal under manufacturing conditions designed based on data in a previous batch, thereby a silicon single crystal having a desired crystal quality can be further assuredly manufactured.

In particular, this method is effective in achievement of a crystal quality in which a manufacturing margin is relatively narrow like an N-region single crystal. The manufacturing margin achieving this N region is narrowed as a crystal diameter is increased. When the diameter is as small as, e.g., less than 200 mm, the N-region single crystal can be likewise manufactured with a certain degree of process yield and productivity by the conventional method, but manufacture is difficult when the diameter is 200 mm or above.
On the other hand, in the manufacturing method according to the present invention, its effectiveness starts to be particularly observed in manufacture of a single crystal having a diameter that is less than 200 mm as well as a single crystal having a diameter of 200 mm or above, and the effect becomes further considerable in case of a single crystal having a large diameter of 300 mm or above.

The present invention will now be explained in more detail hereinafter based on examples and comparative examples, but the present invention is not restricted thereto.

### (Example 1)

A quartz crucible having a bore diameter of 600 mm (24 inches) was used to pull a silicon single crystal having a diameter of 200 mm based on an MCZ method. A crystal quality at this moment was that 80% of an entire length of a straight body forms an N region in the whole area in a radial direction. Moreover, a wire was replaced in a subsequent batch, and a single crystal was pulled by using the new wire.

At this time, the manufacturing system according to the present invention first tentatively designed manufacturing conditions based on achievement data of a previous batch, stretch of the wire was taken into consideration with respect to the tentatively designed manufacturing conditions, and a silicon single crystal was manufactured under manufacturing conditions having a pulling rate corrected by +0.005 mm/min.

As a result, like the previous batch, the crystal quality that 80% of the entire length of the straight body forms an N region in the whole area in the radial direction was obtained, thus reproducing the high-quality single crystal.

### (Comparative Example 1)

A quartz crucible having a bore diameter of 600 mm (24 inches) was used to pull a silicon single crystal having a diameter of 200 mm based on the MCZ method. A crystal quality at this moment was that 80% of an entire length of a straight body forms an N region in the whole area in a radial direction. Additionally, a wire was replaced in a subsequent batch, and a single crystal was pulled by using the new wire.
At this time, a pulling rate was not corrected, and a silicon single crystal was manufactured under the same manufacturing conditions as those in the previous batch.
As a result, as different from the previous batch, the crystal quality of an N region in the whole area in the radial direction was not provided over the entire length of the straight body, a dislocation cluster was generated, and one entire crystal was failure in quality.

### (Example 2)

A quartz crucible having a bore diameter of 800 mm (32 inches) was used to pull a silicon single crystal having a diameter of 300 mm based on the MCZ method. A crystal quality at this moment was that 60% of an entire length of a straight body forms an N region in the whole area in a radial direction. Further, a graphite crucible was replaced in a subsequent batch to pull a single crystal.
Thus, the manufacturing system according to the present invention was used to correct a part in the straight body which does not form an N region in the whole area in the radial direction by +0.002 mm/min in the subsequent batch based on achievement data in a previous batch and to manufacture a silicon single crystal under manufacturing conditions having an overall pulling rate shifted -0.001 mm/min while considering change of a variation in a crucible position required to maintain the same melt level position that is involved by replacement of the graphite crucible.
As a result, the crystal quality that 70% of the entire length of the straight body forms the N region in the whole area in the radial direction was provided, and a yield of the N region in the whole area in the radial direction was improved as compared with that in the previous batch. As explained above, the present invention can not only reproduce the silicon single crystal in the previous batch even though the in-furnace constituent member is replaced but also achieve an improvement so as to provide a further desired crystal quality.

### (Comparative Example 2)

A quartz crucible having a bore diameter of 800 mm (32 inches) was used to pull a silicon single crystal having a diameter of 300 mm based on the MCZ method. A crystal quality at this moment was that 60% of an entire length of a straight body forms an N region in the whole area in a radial direction. Further, a heater was replaced in a subsequent batch. Thus, in the subsequent batch, a part of the straight body alone which does not form the N region in the whole area in the radial direction was corrected by - 0.002 mm/min based on achievement data in a previous batch, but an influence of replacement of the heater on G was not taken into consideration. A silicon single crystal was manufactured under such manufacturing conditions.
As a result, the crystal quality that an N region in the whole area in the radial direction is limited to 20% with respect to the entire length of the straight body was provided, and a yield of an N region in the whole area in the radial direction was greatly reduced as compared with that in the previous batch.

### (Example 3)

A quartz crucible having a bore diameter of 800 mm (32 inches) was used to pull a silicon single crystal having a diameter of 300 mm based on the MCZ method. A crystal quality at this moment was that 60% of an entire length of a straight body forms an N region in the whole area in a radial direction. Further, a heater was replaced in a subsequent batch. Thus, in the subsequent batch, a part of the straight body that does not form the N region in the whole area in the radial direction was corrected by -0.002 mm/min based on achievement data of a previous batch, an influence of replacement of the heater on G was taken into consideration, and a silicon single crystal was manufactured under manufacturing conditions in which G is corrected by upwardly shifting a position of the heater by 20 mm.
As a result, the crystal quality that 70% of the entire length of the straight body forms an N region in the whole area in the radial direction was provided, and a yield of an N region in the whole area in the radial direction was improved as compared with the previous batch.

### (Comparative Example 3)

In a situation where a quartz crucible having a bore diameter of 800 mm (32 inches) is used to pull a silicon single crystal having a diameter of 300 mm based on the MCZ method, information of a root of results to be fed back from achievement data of a previous batch to next manufacturing conditions was fed back to design the next manufacturing conditions, and ten silicon single crystal ingots were manufactured in such a manner that each crystal can have an N region in the whole area in a radial direction.
As a result, an average N region achievement ratio was 40%.

### (Example 4)

In a situation where a quartz crucible having a bore diameter of 800 mm (32 inches) is used to pull a silicon single crystal having a diameter of 300 mm based on the MCZ method, information of a root of results to be fed back from achievement data of a previous batch to next manufacturing conditions was fed back to tentatively design the next manufacturing conditions, and correction amounts obtained from information of constituent members of a pulling apparatus, i.e., information of a root of factors, were added to design manufacturing conditions for a next pulling operation, thereby ten silicon single crystal ingots were manufactured.
At this moment, as the information of a root of factors, execution/inexecution of replacement of a wire, execution/inexecution of replacement of a heater and an operating time of the same, a weight of the quartz crucible, an adjustment amount of a position of the quartz crucible involved by a change with time of a graphite crucible were taken into consideration.
As a result, an average N region achievement ratio became 80%, which is a very high achievement ratio.

It is to be noted that the present invention is not restricted to the foregoing embodiments. The foregoing embodiments are just exemplifications, and any examples that have substantially the same structures and demonstrate the same functions and effects as those in the technical concept described in claims of the present invention are included in the technical scope of the present invention.

## Claims

1. A system for manufacturing a silicon single crystal which designs manufacturing conditions under which a value of a ratio F/G between a pulling rate F and a temperature gradient G of a crystal solid-liquid interface along an axis direction is controlled to fall within a predetermined range in order that a crystal quality of a silicon single crystal manufactured by a pulling apparatus using the Czochralski method falls within a target standard, comprising, based on automation, at least:
means 1 for tentatively designing manufacturing conditions of a silicon single crystal that is manufactured in a subsequent batch from a crystal quality result of a silicon single crystal manufactured in a previous batch;
means 2 for predicting an amount of change in F and/or G in the subsequent batch caused due to constituent members of the pulling apparatus used in the subsequent batch and calculating a correction amount so that a value of F/G is controlled to fall within the predetermined range,
whereas constituent members are at least one of:
a wire to pull the silicon single crystal to be manufactured,
a quartz crucible that accommodates a raw material of the silicon single crystal,
a graphite crucible that supports the quartz crucible, and
a heater that melts the raw material of the silicon single crystal;
means 3 for predicting an amount of change in F and/or G in the subsequent batch caused due to a manufacturing process in the subsequent batch and calculating a correction amount so that a value of F/G is controlled to fall within the predetermined range
whereas manufacturing process are at least one of:
a time from end of melting the raw material to start of pulling the silicon single crystal, and
a difference between a cumulative length of silicon single crystals pulled before and a cumulative length as an initial setting in the same batch in multi-pulling; and
means 4 for adding the correction amount for F and/or G calculated by the means 2 and/or the means 3 to the manufacturing conditions tentatively designed by the means 1 to calculate manufacturing conditions of the silicon single crystal that is manufactured in the subsequent batch.

2. The system for manufacturing a silicon single crystal according to claim 1, wherein the means 2 performs the calculation from at least replacement and/or a change with time of the constituent members of the pulling apparatus used in the subsequent batch.

3. A method for manufacturing a silicon single crystal that uses the system for manufacturing a silicon single crystal according to claim 1 or 2 to manufacture a silicon single crystal.

4. The method for manufacturing a silicon single crystal according to claim 3, wherein an N-region single crystal is manufactured.

5. The method for manufacturing a silicon single crystal according to claim 3 or 4, wherein a correction amount calculated by the means 2 and/or the means 3 is periodically reviewed.

## Patentansprüche

1. System für die Fertigung eines Siliciumeinkristalls, welches Fertigungsbedingungen gestaltet, unter welchen der Wert eines Verhältnisses F/G zwischen einer Ziehrate F und einem Temperaturgradienten G einer Kristallfeststoff-Flüssigkeit-Grenzfläche entlang einer Achsenrichtung so einreguliert wird, dass er in einen vorbestimmten Bereich fällt, damit die Kristallqualität eines Siliciumeinkristalls, welcher durch eine Ziehvorrichtung mit Hilfe des Czochralski-Verfahrens gefertigt wurde, in einen Standardzielbereich fällt, umfassend, auf Basis einer Automatisierung, mindestens Folgendes:
Mittel 1 für das vorläufige Auslegen von Fertigungsbedingungen eines Siliciumeinkristalls, der in einem nachfolgenden Batch von einem Kristallqualitätsergebnis eines in einem vorausgehenden Batch gefertigten Siliciumeinkristalls gefertigt wird;
Mittel 2 für das Vorhersagen eines Veränderungsgrades bezüglich F und/oder G in einem nachfolgenden Batch, verursacht durch Konstituententeile der Ziehvorrichtung, die in dem nachfolgenden Batch eingesetzt wird, und für das Berechnen einer Korrekturmenge, so dass der Wert von F/G so einreguliert wird, dass er in den vorbestimmten Bereich fällt,
wohingegen Konstituententeile mindestens eines aus:
einem Draht zum Ziehen des zu fertigenden Siliciumeinkristalls,
einem Quarz-Tiegel, welcher ein Rohmaterial des Siliciumeinkristalls aufnimmt,
einem Graphit-Tiegel, welcher den Quarz-Tiegel unterstützt, und
einer Heizeinrichtung, welche das Rohmaterial des Siliciumeinkristalls schmilzt, sind;
Mittel 3 für das Vorhersagen eines Veränderungsgrades bezüglich F und/oder G im nachfolgenden Batch, verursacht aufgrund eines Fertigungsverfahrens im nachfolgenden Batch, und für das Berechnen einer Korrekturmenge, so dass der Wert von F/G so einreguliert wird, dass er in den vorbestimmten Bereich fällt,
wohingegen das Fertigungsverfahren mindestens eines aus:
der Zeit vom Ende des Schmelzens des Rohmaterials bis zum Beginn des Ziehens des Siliciumeinkristalls und
dem Unterschied zwischen der kumulativen Länge von zuvor gezogenen Siliciumeinkristallen und der kumulativen Länge als einer Anfangseinstellung im gleichen Batch beim Mehrfachziehen ist; und
Mittel 4 zum Hinzufügen der Korrekturmenge für F und/oder G, berechnet durch das Mittel 2 und/oder das Mittel 3, zu den Fertigungsbedingungen, die vorläufig durch das Mittel 1 gestaltet wurden, um die Fertigungsbedingungen des Siliciumeinkristalls zu berechnen, der in dem nachfolgenden Batch gefertigt wird.

2. System für die Fertigung eines Siliciumeinkristalls gemäß Anspruch 1, wobei das Mittel 2 die Berechnung von mindestens der Versetzung (replacement) und/oder einer Änderung mit der Zeit der Konstituententeile der Ziehvorrichtung, welche im anschließenden Batch verwendet wird, durchführt.

3. Verfahren für die Fertigung eines Siliciumeinkristalls, welches das System zum Fertigen eines Siliciumeinkristalls gemäß Anspruch 1 oder 2 zur Fertigung eines Siliciumeinkristalls anwendet.

4. Verfahren für die Fertigung eines Siliciumeinkristalls gemäß Anspruch 3, wobei ein N-Region-Einkristall gefertigt wird.

5. Verfahren für die Fertigung eines Siliciumeinkristalls gemäß Anspruch 3 oder 4, wobei die durch das Mittel 2 und/oder das Mittel 3 berechnete Korrekturmenge periodisch überprüft wird.

## Revendications

1. Système de fabrication d'un monocristal de silicium qui conçoit des conditions de fabrication sous lesquelles une valeur d'un rapport F/G entre une vitesse de tirage F et un gradient de température G d'une interface solide cristallin-liquide dans le sens d'un axe est contrôlée de manière à tomber dans une plage prédéterminée afin qu'une qualité de cristal d'un monocristal de silicium fabriqué par un appareil de tirage en utilisant la méthode de Czochralski tombe dans une norme cible, comprenant, sur la base d'une automatisation, au moins:
un moyen 1 pour tenter de concevoir des conditions de fabrication d'un monocristal de silicium qui est fabriqué dans un lot suivant à partir d'un résultat de qualité de cristal d'un monocristal de silicium fabriqué dans un lot précédent;
un moyen 2 pour prédire une quantité de changement de F et/ou G dans le lot suivant due à des éléments constituants de l'appareil de tirage utilisé dans le lot suivant et calculer une quantité de correction de manière à ce qu'une valeur de F/G soit contrôlée pour tomber dans la plage prédéterminée,
dans lequel les éléments constituants sont au moins un parmi:
un fil pour tirer le monocristal de silicium devant être fabriqué,
un creuset en quartz qui reçoit une matière première du monocristal de silicium,
un creuset en graphite qui supporte le creuset en quartz, et
un dispositif de chauffage qui fait fondre la matière première du monocristal de silicium;
un moyen 3 pour prédire une quantité de changement de F et/ou G dans le lot suivant due à un procédé de fabrication dans le lot suivant et calculer une quantité de correction de manière à ce qu'une valeur de F/G soit contrôlée pour tomber dans la plage prédéterminée
dans lequel le procédé de fabrication est au moins un parmi:
une durée de la fin de la fusion de la matière première au début du tirage du monocristal de silicium, et
une différence entre une longueur cumulée de monocristaux de silicium tirés auparavant et une longueur cumulée comme un réglage initial dans le même lot dans un tirage multiple; et
un moyen 4 pour ajouter la quantité de correction pour F et/ou G calculée par le moyen 2 et/ou le moyen 3 aux conditions de fabrication tentées d'être conçues par le moyen 1 pour calculer des conditions de fabrication du monocristal de silicium qui est fabriqué dans le lot suivant.

2. Système de fabrication d'un monocristal de silicium selon la revendication 1, dans lequel le moyen 2 effectue le calcul à partir au moins d'un remplacement et/ou d'un changement avec le temps des éléments constituants de l'appareil de tirage utilisé dans le lot suivant.

3. Procédé de fabrication d'un monocristal de silicium qui utilise le système de fabrication d'un monocristal de silicium selon la revendication 1 ou 2 pour fabriquer un monocristal de silicium.

4. Procédé de fabrication d'un monocristal de silicium selon la revendication 3, dans lequel un monocristal de région N est fabriqué.

5. Procédé de fabrication d'un monocristal de silicium selon la revendication 3 ou 4, dans lequel une quantité de correction calculée par le moyen 2 et/ou le moyen 3 est périodiquement revue.
